(19) **Europäisches Patentamt / European Patent Office / Office européen des brevets**

(11) **EP 4 364 212 B1**

(12) **FASCICULE DE BREVET EUROPEEN**

(45) Date de publication et mention
de la délivrance du brevet:
**04.06.2025 Bulletin 2025/23**

(21) Numéro de dépôt: **22744286.0**

(22) Date de dépôt: **27.06.2022**

(51) Classification Internationale des Brevets (IPC):
**H10H 29/01** *(2025.01)*

(52) Classification Coopérative des Brevets (CPC):
**H10H 20/01;** H10H 20/01335; H10H 20/813;
H10H 20/819

(86) Numéro de dépôt international:
**PCT/FR2022/051268**

(87) Numéro de publication internationale:
**WO 2023/275471 (05.01.2023 Gazette 2023/01)**

(54) **PROCEDE DE REALISATION DE DIODES ELECTROLUMINESCENTES**

VERFAHREN ZUR HERSTELLUNG VON LEUCHTDIODEN

PROCESS FOR PRODUCING LIGHT-EMITTING DIODES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.07.2021 FR 2107203**

(43) Date de publication de la demande:
**08.05.2024 Bulletin 2024/19**

(73) Titulaire: **Commissariat à l'Energie Atomique et
aux Energies
Alternatives
75015 Paris (FR)**

(72) Inventeurs:
• **DAUDIN, Bruno
  38054 GRENOBLE CEDEX 09 (FR)**
• **GAYRAL, Bruno
  38054 GRENOBLE CEDEX 09 (FR)**

(74) Mandataire: **Brevalex
Tour Trinity
1 B Place de la Défense
92400 Courbevoie (FR)**

(56) Documents cités:
EP-A1- 0 526 266      WO-A1-2021/115934
WO-A2-2019/202258    JP-A- S59 231 881
US-A1- 2013 293 799   US-A1- 2021 098 648

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

## DOMAINE TECHNIQUE

L'invention concerne le domaine de la réalisation de diodes électroluminescentes, ou LEDs (« Light-Emitting Diodes » en anglais). L'invention concerne notamment la réalisation d'un dispositif d'affichage à LEDs, et plus particulièrement la réalisation d'un micro-dispositif d'affichage à LEDs.

## ÉTAT DE LA TECHNIQUE ANTÉRIEURE

Les dispositifs d'affichage, notamment les micro-dispositifs d'affichage utilisés par exemple pour les écrans de smartphone, comportent un ensemble de pixels. Lorsque le dispositif d'affichage correspond à un écran couleur, chaque pixel peut comporter au moins trois LEDs ou micro-LEDs, formant chacune un sous-pixel, émettant chacune localement l'une des trois couleurs élémentaires ou primaires suivantes : rouge, vert et bleu. On parle dans ce cas de pixels RGB.

Un tel dispositif d'affichage est généralement réalisé en assemblant les différentes LEDs sur un support, pour un grand nombre de pixels. Cette étape d'assemblage est délicate à réaliser sans défauts. Cela est particulièrement critique lors de la réalisation de petits dispositifs d'affichage à haute résolution. Or, un seul de ces défauts produit un pixel dit « noir » n'émettant pas la couleur souhaitée, ce qui est inacceptable pour un dispositif d'affichage destiné au commerce.

Les LEDs utilisées pour la réalisation d'un dispositif d'affichage comportent généralement des matériaux organiques et sont appelées OLEDs (« Organic Light Emitting Diodes » en anglais). L'émission des trois couleurs rouge, vert et bleu est obtenue en réalisant les OLEDs à partir de matériaux organiques différents. Pour chaque couleur, des structures de grandes surfaces sont fabriquées, puis découpées en petits éléments correspondant chacun à une LED, préalablement à l'assemblage final. Cette solution est coûteuse et a une fiabilité limitée.

En outre, la luminance des dispositifs d'affichage à base d'OLEDs est limitée, ce qui est particulièrement gênant dans le cas de pixels de très faibles dimensions utilisés dans des dispositifs d'affichage à haute résolution.

Cette luminance peut être améliorée en réalisant des LEDs à partir de semi-conducteurs inorganiques. Par exemple, les matériaux semi-conducteurs à base de nitrure permettent de fabriquer des LEDs très efficaces pour réaliser une émission lumineuse de couleur bleu et, dans une moindre mesure, de couleur verte. En particulier, il est possible de réaliser des hétérostructures GaN/InGaN formant des puits quantiques et dans lesquelles la quantité d'indium incorporée est ajustée afin de modifier la longueur d'onde d'émission des LEDs. Cependant, ces matériaux semi-conducteurs à base de nitrure ne permettent pas d'obtenir, avec cette même technologie, des LEDs émettant une lumière de couleur rouge qui soient aussi efficaces que celles émettant dans les gammes de longueurs d'onde correspondant aux couleurs bleue ou verte. Il est donc nécessaire, pour former des sous-pixels rouges, de faire appel à une autre famille de matériaux, à savoir celle des phosphures (GaP/GaInP). Cette complication technique pour la réalisation des LEDs ainsi que les difficultés liées à l'assemblage sans défaut d'un grand nombre de LEDs limitent actuellement les performances et la taille des dispositifs d'affichage réalisables avec cette technique.

Il est également connu de réaliser des LEDs monochromatiques par implantation d'ions de terres rares dans des nanofils de GaN ou d'AlN. Toutefois, cette solution se retrouve également confrontée aux problèmes liés à l'assemblage des sous-pixels ainsi réalisés et aux défauts qui en résultent.

Le document de S. Ichikawa et al., « Eu-doped GaN and InGaN monolithically stacked full-color LEDs with a wide color gamut", 2021 Appl. Phys. Express 14 031008, propose une réalisation de LEDs sous la forme d'un empilement vertical monolithique comportant trois couches actives empilées émettant chacune dans l'une des couleurs primaires. L'une de ces couches actives comporte des atomes d'europium et est utilisée pour réaliser une émission lumineuse de couleur rouge. Les deux autres couches actives comportent des puits quantiques d'InGaN dont la composition chimique est ajustée pour émettre dans le bleu pour l'une de ces deux couches, et dans le vert pour l'autre de ces deux couches. La solution proposée dans ce document répond au problème d'assemblage exposé précédemment, mais elle requiert de multiples étapes technologiques pour pouvoir prendre les contacts électriques de chacune des LEDs à différents niveaux de l'empilement.

EP 0526266 A1 divulgue un procédé de réalisation de diodes électroluminescentes, comportant la réalisation d'une portion de semi-conducteur inorganique à travers un masque comprenant une ouverture.

## EXPOSÉ DE L'INVENTION

Un but de la présente invention est de proposer un procédé de réalisation de diodes électroluminescentes, ou LEDs, ne présentant pas les inconvénients des procédés de l'art antérieur précédemment décrits.

Pour cela, il est proposé un procédé de réalisation de diodes électroluminescentes, comportant au moins :

- réalisation d'au moins une portion de semi-conducteur inorganique dopé selon un premier type de conductivité ;
- réalisation, sur la portion de semi-conducteur inorganique dopé selon le premier type de conductivité et à travers au moins un masque comprenant au moins une ouverture disposée en regard d'au moins une première région de la portion de semi-conducteur inorganique dopé selon le premier type de conductivité, d'au moins une première portion émissive de semi-conducteur inorganique ;

- déplacement du masque tel que l'ouverture soit disposée en regard d'au moins une deuxième région, distincte de la première région, de la portion de semi-conducteur inorganique dopé selon le premier type de conductivité ;

- réalisation, sur la portion de semi-conducteur inorganique dopé selon le premier type de conductivité et à travers le masque, d'au moins une deuxième portion émissive de semi-conducteur inorganique ;

- réalisation, au moins sur les première et deuxième portions émissives, d'au moins une portion de semi-conducteur inorganique dopé selon un deuxième type de conductivité opposé au premier type de conductivité ;

dans lequel les compositions chimiques des première et deuxième portions émissives sont différentes l'une de l'autre et telles que leurs énergies de bande interdite soient inférieures ou égales à celles des portions de semi-conducteur inorganique dopé.

Ce procédé propose la réalisation d'au moins deux LEDs, dans lequel la première portion émissive et les parties des portions de semi-conducteur dopé localisées de part et de d'autre de cette première portion émissive forment une première LED. Cette première LED est définie géométriquement (forme et dimensions), dans un plan parallèle à des faces principales (faces ayant les plus grandes surfaces et qui sont traversées par la première ouverture) du masque, par l'ouverture du masque qui délimite et localise cette première portion émissive.

De même, la deuxième portion émissive et les parties des portions de semi-conducteur dopé localisées de part et de d'autre de cette deuxième portion émissive forment une deuxième LED. Cette deuxième LED est définie géométriquement (forme et dimensions), dans un plan parallèle à des faces principales (faces ayant les plus grandes surfaces et qui sont traversées par la deuxième ouverture) du masque, par l'ouverture du masque qui a été déplacée par rapport à la réalisation de la première portion émissive et qui délimite et localise cette deuxième portion émissive.

Ce procédé propose donc une solution technique pour la réalisation, par exemple sur une importante surface, de plusieurs LEDs, sans assemblage de ces LEDs ni d'étapes complexes pour pouvoir prendre des contacts électriques sur ces LEDs.

Ce procédé permet de réaliser différentes LEDs émettant dans des gammes de longueurs d'ondes différentes, dans un même niveau, par intégration horizontale en évitant les inconvénients de l'intégration verticale et les complications technologiques associées.

Ce procédé propose de réaliser de manière localisée des LEDs aptes à émettre des lumières de longueurs d'ondes différentes du domaine visible qui dépendent des compositions chimiques des portions émissives réalisées. Les LEDs sont donc réalisés successivement *in-situ* dans un même empilement semi-conducteur, évitant ainsi la mise en œuvre ultérieure d'un assemblage de LEDs.

En outre, ce procédé ne fait pas appel à des matériaux organiques et permet potentiellement l'obtention d'une meilleure luminance que celle obtenue pour les OLEDs.

Dans tout le document, le terme « LED » est utilisé pour désigner une LED ou une micro-LED, sans distinction de ses dimensions.

Les énergies de bande interdite des portions de semi-conducteur inorganique dopé peuvent être différentes, et dans ce cas, l'énergie de bande interdite de l'une des portions émissives peut être inférieure ou égale à celle de la portion de matériau inorganique dopé de plus faible énergie de bande interdite.

La différence entre les compositions chimiques des différentes portions émissives réalisées peut être obtenue en incorporant des ions de terres rares de nature différente dans les différentes portions émissives et/ou en réalisant les différentes portions émissives avec des composés chimiques comprenant des atomes de natures différentes (par exemple AlGaN, InGaN, etc) et/ou dont les proportions sont différentes (par exemple $In_XGa_{(1-x)}N$ et $In_YGa_{(1-Y)}N$ avec X de valeur différente de Y).

Chacune des incorporations d'ions de terres rares pouvant être mises en œuvre dans ce procédé correspond à une incorporation d'au moins un type d'ions de terres rares. Autrement dit, chacune des incorporations peut correspondre à une incorporation d'ions de terres rares d'un ou plusieurs types différents, et éventuellement d'atomes ne correspondant pas à des ions de terres rares. Par exemple, pour optimiser le processus chimique d'émission de lumière des ions de terres rares pour une couleur donnée, il est possible de réaliser dans la même portion émissive un codopage de terres rares éventuellement différents, accompagnés d'atomes ne correspondant pas à des ions de terres rares. Par exemple, pour une émission dans le rouge, on peut réaliser un codopage d'Europium et d'Oxygène.

L'incorporation d'ions de terres rares au sens de l'invention correspond à l'utilisation de flux atomiques comportant des terres rares dans le bâti, par exemple de type MBE (« Molecular Beam Epitaxy » en anglais, ou épitaxie par jet moléculaire), de réalisation des portions émissives, et par exemple par épitaxie de ces portions émissives.

Chacune des diodes électroluminescentes réalisées peut comporter une seule portion émissive disposée entre les portions de semi-conducteur inorganique dopé, ou bien un empilement de plusieurs portions émissives séparées les unes des autres par une ou plusieurs couches barrières dont l'énergie de bande interdite soit supérieure à celles des portions émissives, l'empilement étant disposé entre les portions de semi-conducteur inorganique dopé.

En outre, chacune des étapes de réalisation de portions émissives mises en œuvre peut former une ou plusieurs portions émissives, en fonction du nombre d'ouvertures du masque utilisé.

Le déplacement du masque correspond à un déplacement relatif du masque vis-à-vis de la portion de semi-conducteur inorganique dopé selon le premier type de conductivité sur laquelle les portions émissives sont réalisées, c'est-à-dire qu'il possible de mettre en mouvement le masque et/ou la portion de semi-conducteur.

Des premiers ions de terre rare peuvent être incorporés dans le semi-conducteur inorganique de la première portion émissive et/ou des deuxièmes ions de terre rare peuvent être incorporés dans le semi-conducteur inorganique de la deuxième portion émissive.

Selon un exemple de réalisation particulier, les premiers ions de terre rare peuvent être incorporés dans le semi-conducteur inorganique de la première portion émissive et les deuxièmes ions de terre rare, de nature différente des premiers ions de terre rare, peuvent être incorporés dans le semi-conducteur inorganique de la deuxième portion émissive.

Le procédé peut comporter en outre, après la réalisation de la deuxième portion émissive et avant la réalisation de la portion de semi-conducteur inorganique dopé selon le deuxième type de conductivité :

- un déplacement du masque tel que l'ouverture soit disposée en regard d'au moins une troisième région, distincte des première et deuxième régions, de la portion de semi-conducteur inorganique dopé selon le premier type de conductivité, puis
- une réalisation, sur la portion de semi-conducteur inorganique dopé selon le premier type de conductivité et à travers le masque, d'au moins une troisième portion émissive de semi-conducteur inorganique dont la composition chimique soit différente de celles des première et deuxième portions émissives et telle que son énergie de bande interdite soit inférieure ou égale à celles des portions de semi-conducteur inorganique dopé.

Selon un exemple de réalisation particulier, des troisièmes ions de terres rares de nature différente de celle des premiers et deuxièmes ions de terre rare peuvent être incorporés dans la troisième portion émissive, et/ou la troisième portion émissive peut comporter un composé chimique comprenant des atomes de natures différentes ou dont les proportions sont différentes des composés chimiques des première et deuxième portions émissives.

De manière avantageuse, les compositions chimiques des première, deuxième et troisième portions émissives peuvent être choisies telles que les première, deuxième et troisième portions émissives soient chacune aptes à émettre des longueurs d'onde correspondant à l'une des couleurs rouge, vert et bleu. Dans un exemple de réalisation particulier, des ions de terres rares incorporés dans les première, deuxième et troisième portions émissives peuvent être choisis parmi des ions europium (permettant l'émission de lumière rouge), terbium et/ou erbium (permettant l'émission de lumière verte), et thulium (permettant l'émission de lumière bleue). Il est également possible d'utiliser des ions praséodyme (permettant l'émission de lumière rouge) et/ou holmium (permettant l'émission de lumière verte) et/ou cérium (permettant l'émission de lumière bleue).

Le procédé peut comporter en outre, après la réalisation de la troisième portion émissive et avant la réalisation de la portion de semi-conducteur inorganique dopé selon le deuxième type de conductivité :

- un déplacement du masque tel que l'ouverture soit disposée en regard d'au moins une quatrième région, distincte des première, deuxième et troisième régions, de la portion de semi-conducteur inorganique dopé selon le premier type de conductivité, puis
- une réalisation, sur la portion de semi-conducteur inorganique dopé selon le premier type de conductivité et à travers le masque, d'au moins une quatrième portion émissive de semi-conducteur inorganique dont la composition chimique soit similaire à celle de l'une des première, deuxième et troisième portions émissives.

Selon un exemple de réalisation particulier, des quatrièmes ions de terres rares de nature similaire à celle des premiers ou deuxièmes ou troisièmes ions de terre rare peuvent être incorporés dans la quatrième portion émissive, et/ou la quatrième portion émissive peut comporter un composé chimique comprenant des atomes de natures similaires et dont les proportions sont similaires au composé chimique de l'une des première, deuxième et troisième portions émissives.

Dans ce cas, les première, deuxième, troisième et quatrième portions émissives peuvent avantageusement être réalisées telles qu'elles soient agencées en formant une matrice.

Le masque utilisé pour la réalisation de chacune des portions émissives correspond à un masque dur.

Les étapes de réalisation des portions de semi-conducteur inorganique dopé et des portions émissives peuvent comporter chacune la mise en œuvre d'une épitaxie ou d'un dépôt.

Avantageusement, les portions de semi-conducteur inorganique dopé et les portions émissives peuvent comporter des composés chimiques comprenant des atomes d'azote ainsi que des atomes d'aluminium et/ou de gallium et/ou d'indium. Ainsi, les semi-conducteurs III-N réalisés dans ce procédé peuvent correspondre à du GaN ou de l'AlN ou de l'InN et leurs alliages ternaires ou quaternaires (AlGaN, InGaN, InAlN, AlGaInN). L'utilisation de tels semi-conducteurs à base de nitrure sont particulièrement avantageux car :

- l'efficacité de transfert d'énergie vers les ions de terre rare qui peuvent émettre de la lumière est d'autant plus élevée que la valeur du gap du semi-conducteur est élevée, ce qui est le cas des semi-conducteurs à base de nitrure, et notamment du GaN et de l'AlN et des alliages à base d'AlGaN ;
- en réalisant une portion émissive apte à émettre dans le rouge par incorporation d'Eu, il est possible, avec la famille des semi-conducteurs à base de nitrure et notamment grâce à l'InGaN, de fabriquer d'autres portions émissives émettant dans le bleu et le vert.

Dans un exemple de réalisation avantageux, les portions de semi-conducteur inorganique dopé et les portions émissives peuvent comporter de l'AlN.

De manière avantageuse, le procédé peut comporter en outre, avant la réalisation de la portion de semi-conducteur inorganique dopé selon le premier type de conductivité, une réalisation d'au moins une portion, dite de base, de semi-conducteur dopé selon le premier type de conductivité sur un substrat, la portion de semi-conducteur inorganique dopé selon le premier type de conductivité étant réalisée ensuite sur la portion de base. Une telle portion de base permet dans ce cas d'initier une croissance de la première portion de semi-conducteur inorganique dopé selon le premier type de conductivité sur tout type de substrat, par exemple semi-conducteur, amorphe, ou métallique.

De manière avantageuse, la portion de base comporte du GaN ou est composé de GaN.

Les portions de semi-conducteur inorganiques et les portions émissives peuvent être réalisées sous la forme de nanofils ou de couches planaires. La réalisation des portions semi-conductrices sous la forme de nanofils est avantageuse car elle permet d'éviter une éventuelle diffusion latérale des espèces atomiques envoyées lors de la réalisation des LEDs. Il est donc possible d'obtenir une séparation totale des différentes couleurs émises par les différentes portions émissives réalisées.

Dans ce cas, le procédé peut comporter en outre, lorsque les portions de semi-conducteur inorganiques et les portions émissives sont réalisées sous la forme de nanofils, une étape de dépôt d'un matériau isolant électrique entre les nanofils, mise en œuvre après la réalisation de la portion de semi-conducteur inorganique dopé selon le deuxième type de conductivité. Cela permet notamment de passiver les flancs latéraux des nanofils.

Le premier type de conductivité peut correspondre au type n et le deuxième type de conductivité peut correspondre au type p.

Le procédé peut être tel que :

- la portion de semi-conducteur inorganique dopé selon le deuxième type de conductivité est dopée par des atomes de magnésium et/ou d'indium, et/ou
- la portion de semi-conducteur inorganique dopé selon le premier type de conductivité est dopée par des atomes de silicium et/ou de germanium.

Les transitions électroniques impliquées dans une émission lumineuse d'un semi-conducteur dans lequel des ions de terres rares ont été incorporés correspondent à celles se produisant pour des électrons profonds appartenant à la couche électronique 4f des ions de terre rare. L'écrantage de cette couche par les électrons des couches externes rend l'émission très stable et indépendante de la nature du matériau environnant qui peut être cristallin ou amorphe, semi-conducteur ou isolant. Lorsque ces ions de terre rares sont introduits dans un semi-conducteur, les transitions électroniques se produisant dans la couche électronique 4f peuvent être excitées par le passage d'un courant, le retour à l'état fondamental s'accompagnant alors d'une émission lumineuse. L'efficacité de l'excitation et du couplage d'une part et la durée de vie de la luminescence excitée d'autre part sont sensibles à la valeur du gap du semi-conducteur dans lequel les ions de terres rares sont incorporés. Plus ce gap est élevé, plus l'efficacité totale augmente.

De manière avantageuse, dans le procédé décrit ici, le dopage par des atomes de magnésium et d'indium du semi-conducteur dopé p permet d'utiliser des semi-conducteurs à grands gap comme par exemple l'AlN, ce qui permet d'obtenir des régions d'émission lumineuse ayant une très bonne efficacité lumineuse.

La présence d'indium dans le semi-conducteur inorganique dopé selon le deuxième type de conductivité permet d'incorporer, par rapport à ce même semi-conducteur ne comportant pas d'indium, un plus grand nombre d'atomes dopants de magnésium du fait que la concentration atomique de magnésium obtenue est proportionnelle à la quantité d'indium présent dans le semi-conducteur. Ainsi, le niveau de dopage de type p pouvant par exemple être obtenu dans le semi-conducteur de la deuxième portion est dans ce cas plus important et permet d'obtenir une plus grande injection de courant et une meilleure répartition des lignes de courant. Par exemple, la présence d'indium dans de l'AlN ou de l'AlGaN permet d'augmenter la solubilité du magnésium dans ces matériaux d'un facteur égal à environ 10, et augmente donc le niveau de dopage pouvant être obtenu dans ce semi-conducteur.

La possibilité d'incorporer un plus grand nombre d'atomes de magnésium lorsque le semi-conducteur comporte de l'indium est inattendue car ces deux types d'atomes induisent, lorsqu'ils sont introduits séparément en particulier dans de l'AlN, une contrainte compressive. Il n'y a donc pas a priori de raison pour que leur introduction simultanée soit favorable en termes d'énergie élastique accumulée car l'ajout de l'indium ne contribue pas à la relaxation de la contrainte élastique induite par l'ajout du magnésium.

La concentration atomique de magnésium dans le semi-conducteur inorganique dopé selon le deuxième type de conductivité peut être comprise entre $10^{20}$ at/cm$^3$ et $10^{21}$ at/cm$^3$, ou supérieure à $10^{20}$ at/cm$^3$, et/ou la concentration atomique de silicium et/ou de germanium dans le semi-conducteur inorganique dopé selon le premier type de conductivité peut être comprise entre $10^{19}$ at/cm$^3$ et $10^{20}$ at/cm$^3$. Une telle concentration atomique de magnésium est par exemple obtenue lorsque le rapport entre la concentration atomique de magnésium et la concentration atomique d'indium est compris entre 1 et 20, ou entre 1 et 50, voire entre 1 et 100, et de préférence de l'ordre de 10. Cette configuration permet d'obtenir un bon niveau de dopage de type p du semi-conducteur grâce, par exemple, à l'abaissement important de l'énergie d'ionisation effective du magnésium à de tels niveaux de dopage, et donc une bonne injection de courant dans la LED grâce à la conduction électrique de la deuxième portion qui est proche ou similaire à celle d'une électrode métallique.

Il est également proposé un procédé de réalisation d'un dispositif d'affichage, comportant la mise en œuvre du procédé de réalisation de diodes électroluminescentes tel que décrit précédemment.

Ce procédé peut avantageusement être mis en œuvre pour réaliser un dispositif d'affichage à pixels RGB, c'est-à-dire comportant chacun au moins trois sous-pixels émettant des longueurs d'onde correspondant aux couleurs rouge, verte et bleue. Mais d'une manière générale, ce procédé peut être mis en œuvre pour réaliser des dispositifs d'affichage dotés de pixels comportant chacun au moins deux sous-pixels émettant des longueurs d'ondes différentes et qui ne correspondent pas nécessairement à des pixels RGB.

Ce procédé ne présente pas les inconvénients liés à l'assemblage de plusieurs sous-pixels réalisés séparément pour former chacun des pixels du dispositif d'affichage.

Ce procédé peut être mis en œuvre pour réaliser un dispositif d'affichage de grande surface. L'assemblage ultérieur de plusieurs de ces dispositifs peut permettre d'augmenter d'un facteur arbitrairement grand la taille du dispositif final pour atteindre celle d'un écran d'ordinateur ou de télévision ou pour l'affichage mural.

Dans l'ensemble du document, le terme « sur » est utilisé sans distinction de l'orientation dans l'espace de l'élément auquel ce rapporte ce terme. Par exemple, dans la caractéristique « sur une face d'une portion », cette face de la portion n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 7 représentent les étapes mises en œuvre au cours d'un procédé de réalisation de diodes électroluminescentes, objet de la présente invention, selon un premier mode de réalisation ;
- la figure 8 représente des diodes électroluminescentes obtenu par la mise en œuvre d'un procédé de réalisation de diodes électroluminescentes, objet de la présente invention, selon une variante du premier mode de réalisation ;
- la figure 9 représente une diode électroluminescente obtenue par la mise en œuvre d'un procédé de réalisation de diodes électroluminescentes, objet de la présente invention, selon un deuxième mode de réalisation ;
- la figure 10 représente un dispositif d'affichage réalisé en mettant en œuvre un procédé objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

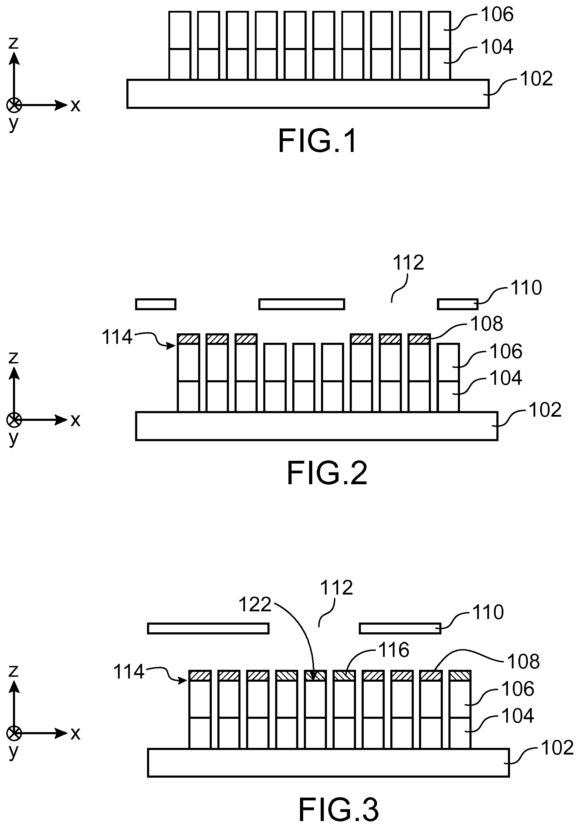

Un procédé de réalisation de LEDs 100 selon un premier mode de réalisation est décrit ci-dessous en lien avec les figures 1 à 7.

Dans l'exemple de réalisation décrit ici, les LEDs 100 sont réalisées sous la forme de nanofils élaborés par épitaxie sur un substrat 102 comportant par exemple du semi-conducteur tel que du silicium, ou bien encore du saphir ou un autre matériau.

De manière avantageuse, les étapes d'épitaxie mises en œuvre ici pour former les nanofils correspondent à des étapes d'épitaxie par jets moléculaires assistée plasma, ou PA-MBE (« Plasma Assisted - Molecular Beam Epitaxy » en anglais). En variante, ces étapes peuvent correspondre à des étapes de dépôt, comme par exemple des dépôts en phase vapeur aux organométalliques, ou MOCVD (« MetalOrganic Chemical Vapor Deposition » en anglais), ou d'épitaxie en phase vapeur aux organométalliques, ou MOVPE (« MetalOrganic Vapor Phase Epitaxy » en anglais), ou encore de dépôts par ablation laser pulsé, ou PLD (« Pulsed Laser Deposition »).

Pour former ces nanofils, dans une première étape, des portions de base 104 de semi-conducteur, avantageusement de GaN, dopé selon un premier type de conductivité sont réalisées par croissance sous la forme de nanofils. La réalisation de ces portions de base 104 est facultative. Ces portions de base 104 permettent de faciliter la croissance ultérieure des autres portions de matériaux des LEDs 100.

Dans cet exemple de réalisation, le premier type de conductivité correspond au type n.

Des portions 106 de semi-conducteur inorganique dopé selon le premier type de conductivité, ici d'AlN dopé n, sont ensuite réalisées par croissance sur les portions 104 (voir figure 1). Par exemple, le dopage n peut être obtenu en introduisant des atomes de silicium et/ou de germanium dans le matériau des portions 106. La concentration de dopants dans le semi-conducteur des portions 106 est par exemple comprise entre $10^{17}$ at/cm$^3$ et $10^{20}$ at/cm$^3$ et avantageusement $10^{19}$ at/cm$^3$ et $10^{20}$ at/cm$^3$. La dimension de chacune des portions 106 parallèle à la direction de croissance des nanofils (dimension parallèle à l'axe Z sur les figures 1 à 7), est par exemple égale à 500 nm, ou plus généralement comprise entre 100 et 1000 nm.

Des premières portions émissives 108 de semi-conducteur inorganique, ici d'AlN, sont ensuite réalisées par croissance à travers un masque 110 comprenant des ouvertures 112 disposées en regard de premières régions 114 des portions 106 (voir figure 2). Ces premières portions émissives 108 sont destinées à faire partie de premières LEDs réalisant une émission lumineuse dans une première gamme de longueurs d'onde. Pour cela, lors de la croissance des premières portions émissives 108, des premiers ions de terres rares sont incorporés dans le semi-conducteur des premières portions émissives 108. Par exemple, lorsque les premières portions émissives 108 sont destinées à émettre une lumière de couleur rouge, les premiers ions de terres rares incorporés peuvent correspondre à des ions europium.

Après avoir réalisé les premières portions émissives 108, le masque 110 est déplacé tel que les ouvertures 112 soient disposées en regard de deuxièmes régions 122, distinctes des premières régions 114, des portions 106.

Des deuxièmes portions émissives 116 de semi-conducteur inorganique, ici d'AlN, sont ensuite réalisées par croissance à travers le masque 110, en regard des ouvertures 112 (voir figure 3). Ces deuxièmes portions émissives 116 sont destinées à faire partie de deuxièmes LEDs réalisant une émission lumineuse dans une deuxième gamme de longueurs d'onde. Pour cela, les deuxièmes portions émissives 116 sont réalisées telles leur composition chimique soit différente de celle des premières portions émissives 108. Dans le premier mode de réalisation, lors de la croissance des deuxièmes portions émissives 116, des deuxièmes ions de terres rares, de nature différente des premiers ions de terres rares, sont incorporés dans le semi-conducteur des deuxièmes portions émissives 116 afin d'obtenir cette différence de composition chimique entre les premières et deuxièmes portions émissives 108, 116. Par exemple, lorsque les deuxièmes portions émissives 116 sont destinées à émettre une lumière de couleur verte, les deuxièmes ions de terres rares incorporés peuvent correspondre à des ions terbium et/ou erbium.

Dans l'exemple de réalisation décrit ici, le masque 110 est de nouveau déplacé tel que les ouvertures 112 soient disposées en regard de troisièmes régions, distinctes des premières et deuxièmes régions 114, 122, des portions 106.

Des troisièmes portions émissives 124 de semi-conducteur inorganique, ici d'AlN, sont ensuite réalisées par croissance à travers le masque 110, en regard des ouvertures 112. Ces troisièmes portions émissives 124 sont destinées à faire partie de troisièmes LEDs réalisant une émission lumineuse dans une troisième gamme de longueurs d'onde. Pour cela, les troisièmes portions émissives 124 sont réalisées telles leur composition chimique soit différente de celle des premières et deuxièmes portions émissives 108, 116. Dans le premier mode de réalisation, lors de la croissance des troisièmes portions émissives 124, des troisièmes ions de terres rares, de nature différente des premiers et deuxièmes ions de terres rares, sont incorporés dans le semi-conducteur des troisièmes portions émissives 124 afin d'obtenir cette différence de composition chimique entre les troisièmes portions émissives 124 d'une part et les premières et deuxièmes portions émissives 108, 116 d'autre part. Par exemple, lorsque les troisièmes portions émissives 124 sont destinées à émettre une lumière de couleur bleue, les troisièmes ions de terres rares incorporés peuvent correspondre à des ions thulium.

Dans l'exemple de réalisation décrit ici, le masque 110 est de nouveau déplacé tel que les ouvertures 112 soient disposées en regard de quatrième régions, distinctes des premières, deuxièmes et troisièmes régions des portions 106.

Des quatrièmes portions émissives 126 de semi-conducteur inorganique, ici d'AlN, sont ensuite réalisées par croissance à travers le masque 110, en regard des ouvertures 112. Ces quatrièmes portions émissives 126 sont destinées à faire partie de quatrièmes LEDs réalisant une émission lumineuse dans une gamme de longueurs d'onde similaire à l'une des première, deuxième ou troisième gammes de longueurs d'onde. Pour cela, les quatrièmes portions émissives 126 sont réalisées telles que leur composition chimique soit similaire à celle des premières portions émissives 108 ou à celle des deuxièmes portions émissives 116 ou à celle des troisièmes portions émissives 124. Dans le premier mode de réalisation, lors de la croissance des quatrièmes portions émissives 126, des quatrièmes ions de terres rares de nature similaire à celle des premiers, deuxièmes ou troisièmes ions de terres rares sont incorporés dans le semi-conducteur des quatrièmes portions émissives 126 afin d'obtenir cette similitude de composition chimique entre les quatrièmes portions émissives 126 et les premières ou deuxièmes ou troisièmes portions émissives 108, 116, 124. Il est par exemple avantageux que les quatrièmes portions émissives 126 soient destinées à émettre une lumière de couleur rouge, comme les premières portions émissives 108, du fait que cette couleur correspond à celle pour laquelle l'émission lumineuse est la moins efficace, les quatrièmes ions de terres rares incorporés pouvant correspondre dans ce cas à des ions europium.

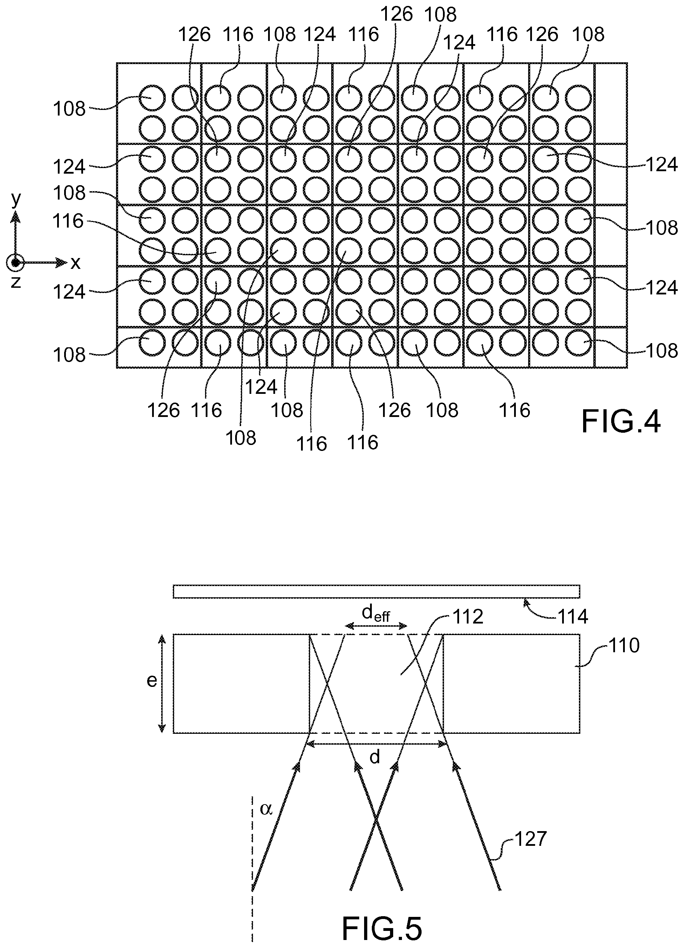

La figure 4 représente schématiquement, vue de dessus, un exemple de répartition des portions émissives 108, 116, 124 et 126 réalisées. Dans cet exemple, ces portions émissives 108, 116, 124, 126 sont agencées en formant une matrice, c'est-à-dire en lignes et colonnes.

La dimension de chacune des portions émissives 108, 116, 124, 126 parallèle à la direction de croissance des nanofils (parallèle à l'axe Z sur les figures 1 à 7) est par exemple comprise entre 5 nm et 50 nm.

Dans un équipement d'épitaxie par jets moléculaire, les flux atomiques produits par les cellules utilisées forment un angle $\alpha$ par rapport à la normale à la surface sur laquelle l'épitaxie est réalisée. La valeur de cet angle dépend notamment de l'équipement et des cellules utilisées, et est par exemple compris entre 25° et 30°. Etant donné que le substrat 102 est en rotation durant la croissance, la valeur d'un diamètre $d_{eff}$ d'une région de la surface sur laquelle l'épitaxie est réalisée et où la densité surfacique de matière épitaxiée est la plus élevée dépend d'une épaisseur e du masque utilisé, d'une dimension d de l'ouverture à travers laquelle l'épitaxie est réalisée (par exemple le diamètre dans le cas d'une ouverture de section circulaire ou la dimension d'un des côtés dans le cas d'une ouverture de section carrée ou rectangulaire), et de l'angle $\alpha$ selon la formule :

$$d_{eff} = d - 2.e.\tan(\alpha)$$

Cette configuration est représentée schématiquement sur la figure 5. Sur cette figure, les flux atomiques produits lors de l'épitaxie portent la référence 127

Par exemple, pour $\alpha = 25°$, $d = 5\ \mu m$ et $e = 1\ \mu m$, la valeur de $d_{eff}$ est égale à environ 4 $\mu m$.

Autour de cette région de diamètre $d_{eff}$, une autre région en forme d'anneau de largeur égale à $e.tan(\alpha)$ est également formée par l'épitaxie. La densité surfacique d'ions de terres rares obtenue dans cette autre région est égale à la moitié de celle déposée dans la région de diamètre $d_{eff}$. La vitesse de croissance dans cette autre région est également réduite de moitié par rapport à celle dans la région centrale de diamètre $d_{eff}$.

Ainsi, la densité volumique d'ions de terres rares est constante sur toute la zone de diamètre d.

L'optimisation de la taille et de la morphologie des LEDs produites dépend donc notamment d'un choix judicieux des paramètres e et d des masques utilisés.

En outre, à titre d'exemple, chaque ouverture peut avoir, dans un plan parallèle à la surface sur laquelle l'épitaxie est mise en œuvre, une section de forme rectangulaire ou carré, par exemple de dimensions comprises entre 2 x 2 $\mu m^2$ et 5 x 5 $\mu m^2$. Lorsque les dimensions d'une des ouvertures sont égales à 2 x 2 $\mu m^2$, le nombre de portions de nanofils se trouvant en regard d'une telle ouverture est par exemple égal à 400.

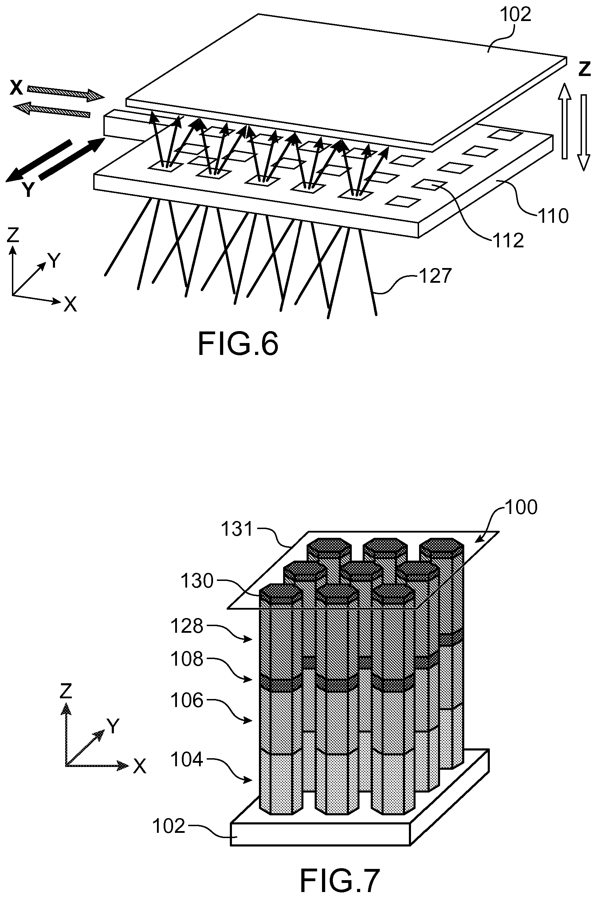

La figure 6 illustre un exemple de mode opératoire pour la réalisation des portions émissives 108, 116, 124 et 126 à travers le masque 110 utilisé pour la réalisation de ces portions émissives. Sur cette figure, des flux atomiques 127 sont envoyés à travers le masque 110 qui est solidaire d'un dispositif permettant de le déplacer selon l'axe Z (pour le rapprocher à la distance souhaitée de la surface de dépôt) et selon les axes X et Y (pour varier la position de la zone exposée aux faisceaux atomiques où est réalisée la croissance).

Le masque peut être réalisé ex situ, c'est-à-dire en dehors du bâti où est réalisée la croissance. Ce masque est par exemple réalisé à partir d'une plaque (wafer) de silicium sur laquelle est déposé du SiN afin de limiter la contamination du wafer grâce au faible taux de collage des flux atomiques sur le SiN, et à travers lequel les ouvertures sont réalisées par exemple par lithographie. Cette lithographie peut également former des nervures afin de conférer une bonne rigidité mécanique au masque.

Des portions 128 de semi-conducteur inorganique dopé selon un deuxième type de conductivité, ici d'AlN dopé p, sont ensuite réalisées par croissance sur les portions 108, 116, 124 et 126. Comme pour la réalisation des portions 106, aucun masque n'est utilisé pour la croissance de ces portions 128.

Le dopage de type p est ici avantageusement obtenu en incorporant des atomes de magnésium et d'indium dans les portions 128. De manière avantageuse, la concentration atomique de magnésium dans le semi-conducteur de ces portions 128 est comprise entre $10^{17}$ at/cm³ et $10^{21}$ at/cm³, et avantageusement comprise entre $10^{20}$ at/cm³ et $10^{21}$ at/cm³.

Pour la croissance du semi-conducteur des portions 128 par MBE, des flux d'aluminium, d'azote actif, d'indium et éventuellement de gallium sont envoyés sur la surface de croissance qui correspond à la surface supérieure des portions émissives 108, 116, 124, 126. Un flux de magnésium est également envoyé pour que le semi-conducteur réalisé soit dopé p par les atomes de magnésium. Les valeurs de ces flux, c'est-à-dire la quantité d'atomes envoyés de chacun de ces éléments chimiques, sont choisies en fonction de la composition souhaitée pour le semi-conducteur des portions 128 et notamment de telle façon que la concentration atomique d'indium soit comprise entre 0 et 1% et préférentiellement égale à 0,1%. En présence de ce flux d'indium, la concentration atomique de magnésium dans le semi-conducteur des portions 128 est proportionnelle à la quantité d'indium incorporée dans ce semi-conducteur et est par exemple comprise entre $10^{17}$ at/cm$^3$ et $10^{21}$ at/cm$^3$, et avantageusement comprise entre $10^{20}$ at/cm$^3$ et $10^{21}$ at/cm$^3$, soit une concentration atomique de magnésium comprise entre 0,1 % et 1 %.

Lors d'une réalisation des portions 128 par croissance par MOCVD, les éléments utilisés pour la croissance du semi-conducteur sont des précurseurs organométalliques, par exemple du triméthylaluminium ou du triéthylaluminium servant de source d'aluminium, de l'ammoniac servant de source d'azote, du triméthylindium ou du triéthylindium servant de source d'indium, et éventuellement du triméthylgallium ou du triéthylgallium servant de source de gallium. Les atomes de magnésium sont obtenus par un précurseur approprié, par exemple une solution de magnésocène ou Mg(Cp)2. Les concentrations d'indium et de magnésium pouvant être obtenues par MOCVD peuvent être similaires à celles obtenues par MBE.

La dimension selon l'axe Z de chacune des portions 128 est avantageusement très courte de façon à optimiser l'injection de courant au sein des pixels 101 réalisés, et par exemple comprise entre 50 nm et 300 nm, et avantageusement entre 50 nm et 100 nm.

De manière avantageuse, la structure de nanofils réalisée est achevée en réalisant par croissance une courte portions 130 de GaN fortement dopé p, ce qui permet de faciliter la prise de contact électrique des LEDs réalisées. L'épaisseur (dimension selon l'axe Z) de la portion 130 est par exemple comprise entre 20 nm et 30 nm.

Le diamètre de chaque nanofil formé par les portions 104, 106, 108 (ou l'une des portions 116, 124, 126) et 128 est par exemple compris entre 100 nm et 150 nm. La période, ou le pas de répétition, avec laquelle les nanofils sont réalisés, qui correspond à la distance entre les centres de deux nanofils voisins, est par exemple comprise entre 150 nm et 300 nm. Selon un exemple de réalisation particulier, la valeur de la période peut être égale au double de celle du diamètre d'un des nanofils.

Selon un exemple de réalisation particulier, les portions 128 et 130 réalisées peuvent être localisées sur les parties centrales des portions émissives 108, 116, 124, 126 de diamètres $d_{eff}$, pour éviter une éventuelle différence d'intensité d'émission qui serait due aux différences de propriétés entre ces parties centrales et le reste des portions émissives 108, 116, 124, 126.

Un contact électrique 131 peut ensuite être déposé sur la structure réalisée. Ce contact électrique 131 comporte un matériau électriquement conducteur et transparent, par exemple de l'oxyde d'indium et étain (ITO).

Cette étape de réalisation du contact électrique 131 peut être précédée d'une étape de passivation et de planarisation, correspondant par exemple à un dépôt de matériau électriquement isolant entre les nanofils. Ce dépôt est par exemple de type ALD (dépôt de couche atomique). Le matériau déposé est par exemple de l'oxyde d'aluminium, ou du SiO$_2$, ou tout autre matériau électriquement isolant adapté pour un tel dépôt. Le dépôt de ce matériau isolant permet de passiver les surfaces latérales des nanofils et limiter les recombinaisons non radiatives de porteurs sur les défauts de surface qui sont préjudiciables à l'efficacité des LEDs 100. Ce dépôt de matériau isolant permet également de donner une certaine résistance mécanique à l'ensemble des nanofils. Une étape de polissage peut ensuite être mise en œuvre pour former un surface plane facilitant le dépôt du contact électrique 131.

La figure 7 représente schématiquement une des LEDs 100 obtenues après la mise en œuvre des étapes décrites ci-dessus.

Dans l'exemple de réalisation décrit précédemment, les matériaux réalisés par croissance correspondent à de l'AlN ou du GaN. De manière plus générale, chacune des différentes portions 104, 106, 108, 116, 124, 126, 128 et 130 peut comporter des composés comprenant des atomes d'azote ainsi que des atomes d'aluminium et/ou de gallium et/ou d'indium. Par exemple, selon une variante, les portions 104 et 106 de chaque nanofil peuvent correspondre à une seule portion de matériau, par exemple de GaN dopé n ou de l'AlGaN dopé n.

En variante du premier mode de réalisation décrit ci-dessus, il est possible de ne pas réaliser les portions 104, et de réaliser les portions 106 directement sur le substrat 102.

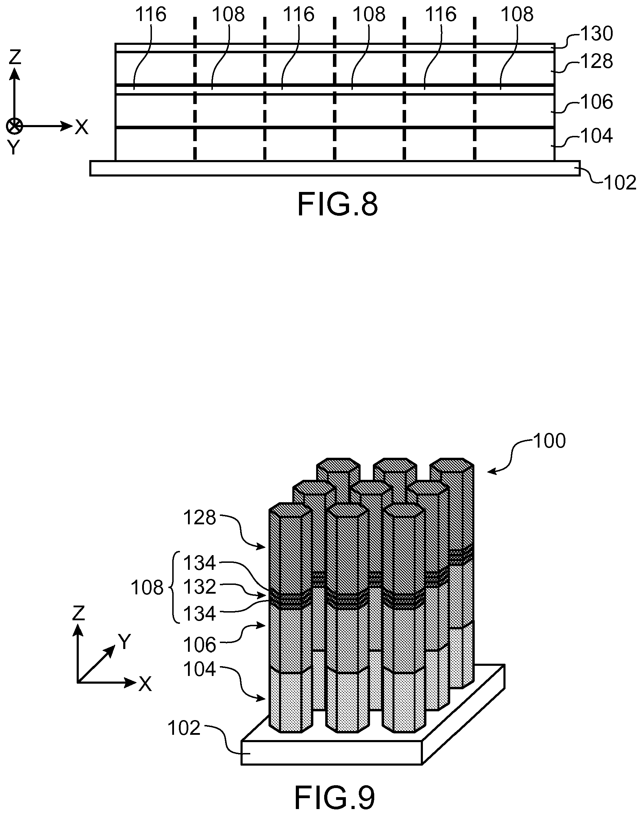

En variante du premier mode de réalisation décrit précédemment dans lequel les différentes portions de matériaux sont réalisées sous la forme de nanofils, il est possible que ces différentes portions soient réalisées sous la forme de couche de matériaux déposées successivement sur le substrat 102. A la différence des nanofils qui forment des structures verticales distinctes formées les unes à côté des autres sur le substrat 102, les couches déposées sur le substrat 102 sont continues entre deux LEDs 100 voisines. La figure 8 représente schématiquement une vue en coupe de la structure obtenue selon cette variante. Les techniques mises en œuvre pour former de telles couches sont avantageusement des dépôts de type MOCVD ou PLD.

Dans le premier mode de réalisation précédemment décrit, les régions d'émission lumineuse des LEDs 100 sont obtenues grâce à l'incorporation d'ion de terres rares dans les portions émissives, conduisant à l'obtention de portions émissives de compositions chimiques différentes.

Dans un deuxième mode de réalisation, les régions d'émission lumineuse des LEDS 100 peuvent être obtenues en réalisant, entre les portions 106 et 128, des structures à un ou plusieurs puits quantiques, ou MQW (« Multiple Quantum Well » en anglais).

La figure 9 représente schématiquement un exemple de réalisation d'une LED 100 selon ce deuxième mode de réalisation. Dans cet exemple de réalisation, une portion émissive est formée, dans chaque nanofil, par un puits quantique d'InGaN disposée entre deux couches barrières de GaN 134. Comme dans le premier mode de réalisation, les puits quantiques formant les portions émissives sont réalisés à travers le masque 110 afin de réaliser successivement, sur les différentes régions des portions 106, des portions émissives aptes à émettre des longueurs d'onde différentes. Contrairement au premier mode de réalisation dans lequel les longueurs d'onde émises par les régions actives dépendent des types d'ions de terre rare incorporés, les longueurs d'onde émises par les différentes portions dépendent, dans ce deuxième mode de réalisation, de la nature et/ou des proportions atomiques des composés chimiques des portions émissives, par exemple le taux d'indium (qui peut être compris entre 1% et 10%, et avantageusement entre 1% et 5%) dans le cas de puits quantiques comprenant de l'InGaN. Comme dans le premier mode de réalisation, les compositions chimiques des puits peuvent être choisies de manière à former des portions émissives aptes à émettre des longueurs d'onde correspondant à la couleur rouge, d'autres aptes à émettre des longueurs d'onde correspondant à la couleur verte, et d'autres aptes à émettre des longueurs d'onde correspondant à la couleur bleue.

Sur l'exemple de la figure 9, chaque nanofil réalisé comporte une seule portion émissive disposée entre deux couches barrières 134. En variante, il est possible que les couches barrières entre lesquelles est disposée la portion émissive soient formées par les portions de semi-conducteur inorganique dopé 106 et 128.

En outre, il est également possible que chaque nanofil un empilement de plusieurs portions émissives séparées les unes des autres par une ou plusieurs couches barrières, par exemple similaires aux couches barrières 134, dont l'énergie de bande interdite soit supérieure à celles des portions émissives, cet empilement étant disposé entre les portions de semi-conducteur inorganique dopé.

Les différentes variantes de réalisation précédemment décrites pour le premier mode de réalisation peuvent s'appliquer au deuxième mode de réalisation.

En outre, selon une variante du deuxième mode de réalisation il est possible qu'une ou plusieurs des portions émissives 108, 116, 124, 126 soit formée par un puits quantique ou un empilement de plusieurs puits quantiques superposés dans lequel ou lesquels des ions de terres rares sont incorporés. Une telle variante est avantageuse car dans ce cas, les portions émissives (par exemple en InGaN) se trouvant entre les couches barrières permettent de déterminer des zones de confinement des porteurs pour maximiser leur présence au voisinage des ions de terres rares, et ainsi maximiser l'efficacité d'excitation des ions de terres rares.

Selon d'autres variantes, il est possible d'avoir certaines des portions émissives incorporant des ions de terres rares et/ou une ou plusieurs autres portions émissives n'incorporant pas d'ions de terres rares.

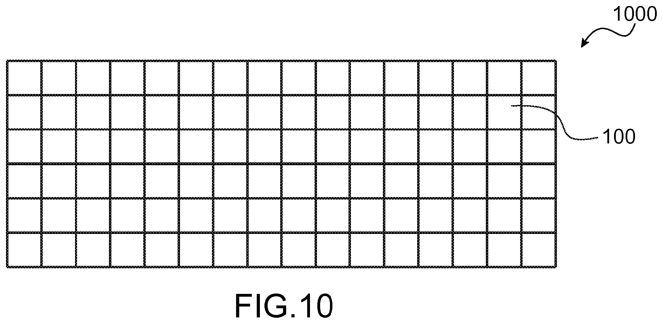

Pour tous les modes de réalisation et variantes décrits précédemment, un dispositif d'affichage 1000, correspondant par exemple à un écran, peut être obtenu en réalisant les pixels de ce dispositif 1000 avec les LEDs 100 précédemment décrites. Par exemple, chaque pixel d'un tel dispositif 1000 peut être formé par quatre LEDs 100 agencés en formant une matrice 2 x 2. Un tel dispositif 1000 est représenté schématiquement sur la figure 10.

## Revendications

1. Procédé de réalisation de diodes électroluminescentes (100), comportant au moins :

   - réalisation d'au moins une portion (106) de semi-conducteur inorganique dopé selon un premier type de conductivité ;
   - réalisation, sur la portion (106) de semi-conducteur inorganique dopé selon le premier type de conductivité et à travers au moins un masque (110) comprenant au moins une ouverture (112) disposée en regard d'au moins une première région (114) de la portion (106) de semi-conducteur inorganique dopé selon le premier type de conductivité, d'au moins une première portion émissive (108) de semi-conducteur inorganique ;
   - déplacement du masque (110) tel que l'ouverture (112) soit disposée en regard d'au moins une deuxième région (122), distincte de la première région (114), de la portion (106) de semi-conducteur inorganique dopé selon le premier type de conductivité ;
   - réalisation, sur la portion (106) de semi-conducteur inorganique dopé selon le premier type de conductivité et à travers le masque (110), d'au moins une deuxième portion émissive (116) de semi-conducteur inorganique ;
   - réalisation, au moins sur les première et deuxième portions émissives (108, 116), d'au moins une portion (128) de semi-conducteur inorganique dopé selon un deuxième type de conductivité opposé au premier type de conductivité ;

   dans lequel les compositions chimiques des première et deuxième portions émissives (108, 116) sont différentes l'une de l'autre et telles que leurs énergies de bande interdite soient inférieures ou égales à celles des portions (106, 128) de semi-conducteur inorganique dopé.

2. Procédé selon la revendication 1, dans lequel des premiers ions de terre rare sont incorporés dans le semi-conducteur inorganique de la première portion émissive (108) et/ou dans lequel des deuxièmes ions de terre rare sont incorporés dans le semi-conducteur inorganique de la deuxième portion émissive (116).

3. Procédé selon la revendication 2, dans lequel les premiers ions de terre rare sont incorporés dans le semi-conducteur inorganique de la première portion émissive (108) et les deuxièmes ions de terre rare, de nature différente des premiers ions de terre rare, sont incorporés dans le semi-conducteur inorganique de la deuxième portion émissive (116).

4. Procédé selon l'une des revendications précédentes, comportant en outre, après la réalisation de la deuxième portion émissive (116) et avant la réalisation de la portion (128) de semi-conducteur inorganique dopé selon le deuxième type de conductivité :

   - un déplacement du masque (110) tel que l'ouverture (112) soit disposée en regard d'au moins une troisième région, distincte des première et deuxième régions (114, 122), de la portion (106) de semi-conducteur inorganique dopé selon le premier type de conductivité, puis
   - une réalisation, sur la portion (106) de semi-conducteur inorganique dopé selon le premier type de conductivité et à travers le masque (110), d'au moins une troisième portion émissive (124) de semi-conducteur inorganique dont la composition chimique soit différente de celles des première et deuxième portions émissives (108, 116) et telle que son énergie de bande interdite soit inférieure ou égale à celles des portions (106, 128) de semi-conducteur inorganique dopé.

5. Procédé selon la revendication 4, dans lequel les compositions chimiques des première, deuxième et troisième portions émissives (108, 116, 124) sont choisies telles que les première, deuxième et troisième portions émissives soient chacune aptes à émettre des longueurs d'onde correspondant à l'une des couleurs rouge, vert et bleu.

6. Procédé selon l'une des revendications 4 ou 5, comportant en outre, après la réalisation de la troisième portion émissive (124) et avant la réalisation de la portion (128) de semi-conducteur inorganique dopé selon le deuxième type de conductivité :

   - un déplacement du masque (110) tel que l'ouverture (112) soit disposée en regard d'au moins une quatrième région, distincte des première, deuxième et troisième régions (114, 122), de la portion (106) de semi-conducteur inorganique dopé selon le premier type de conductivité, puis
   - une réalisation, sur la portion (106) de semi-conducteur inorganique dopé selon le premier type de conductivité et à travers le masque (110), d'au moins une quatrième portion émissive (126) de semi-conducteur inorganique dont la composition chimique soit similaire à celle de l'une des première, deuxième et troisième portions émissives (108, 116, 124).

7. Procédé selon l'une des revendications précédentes, dans lequel les portions (106, 128) de semi-conducteur inorganique dopé et les portions émissives (108, 116, 124, 126) comportent des composés chimiques comprenant des atomes d'azote ainsi que des atomes d'aluminium et/ou de gallium et/ou d'indium.

8. Procédé selon l'une des revendications précédentes, comportant en outre, avant la réalisation de la portion (106) de semi-conducteur inorganique dopé selon le premier type de conductivité, une réalisation d'au moins une portion (104), dite de base, de semi-conducteur, avantageusement de GaN, dopé selon le premier type de conductivité sur un substrat, la portion (106) de semi-conducteur inorganique dopé selon le premier type de conductivité étant réalisée ensuite sur la portion de base (104).

9. Procédé selon la revendication 8, dans lequel la portion de base (104) comporte du GaN.

10. Procédé selon l'une des revendications précédentes, dans lequel les portions (106, 128) de semi-conducteur inorganiques et les portions émissives (108, 116, 124, 126) sont réalisées sous la forme de nanofils ou de couches planaires.

11. Procédé selon la revendication 10, comportant en outre, lorsque les portions (106, 128) de semi-conducteur inorganiques et les portions émissives (108, 116, 124, 126) sont réalisées sous la forme de nanofils, une étape de dépôt d'un matériau isolant électrique entre les nanofils, mise en œuvre après la réalisation de la portion (128) de semi-conducteur inorganique dopé selon le deuxième type de conductivité.

12. Procédé selon l'une des revendications précédentes, dans lequel le premier type de conductivité correspond au type n et le deuxième type de conductivité correspond au type p.

13. Procédé selon l'une des revendications précédentes, dans lequel :

   - la portion (128) de semi-conducteur inorganique dopé selon le deuxième type de conductivité est dopée par des atomes de magnésium et/ou d'indium, et/ou

- la portion (106) de semi-conducteur inorganique dopé selon le premier type de conductivité est dopée par des atomes de silicium et/ou de germanium.

14. Procédé de réalisation d'un dispositif d'affichage (1000), comportant la mise en œuvre du procédé de réalisation de diodes électroluminescentes (100) selon l'une des revendications précédentes.

**Patentansprüche**

1. Verfahren zur Herstellung von Leuchtdioden (100), mindestens umfassend:

- Herstellung mindestens eines anorganischen Halbleiterabschnitts (106), der nach einem ersten Leitfähigkeitstyp dotiert ist;
- Herstellung, auf dem anorganischen Halbleiterabschnitt (106), der nach dem ersten Leitfähigkeitsyp dotiert ist, und durch mindestens eine Maske (110), die mindestens eine Öffnung (112) umfasst, die gegenüber mindestens einem ersten Bereich (114) des anorganischen Halbleiterabschnitts (106), der nach dem ersten Leitfähigkeitstyp dotiert ist, angeordnet ist, von mindestens einem ersten anorganischen Halbleiteremissionsabschnitt (108);
- Verschiebung der Maske (110) so, dass die Öffnung (112) gegenüber mindestens einem zweiten Bereich (122), der sich vom ersten Bereich (114), des anorganischen Halbleiterabschnitts (106), der nach dem ersten Leitfähigkeitstyp dotiert ist, unterscheidet;
- Herstellung, auf dem anorganischen Halbleiterabschnitt (106), der nach dem ersten Leitfähigkeitstyp dotiert ist, und durch die Maske (110), von mindestens einem zweiten anorganischen Halbleiteremissionsabschnitt (116);
- Herstellung, mindestens an den ersten und zweiten Emissionsabschnitten (108, 116), von mindestens einem anorganischen Halbleiterabschnitt (128), der nach einem zweiten Leitfähigkeitstyp dotiert ist, der dem ersten Leitfähigkeitstyp gegenübersteht;

wobei sich die chemischen Zusammensetzungen der ersten und zweiten Emissionsabschnitte (108, 116) voneinander unterscheiden und derart sind, dass ihre verbotene Bandenergien kleiner oder gleich denen der dotierten anorganischen Halbleiterabschnitte (106, 128) sind.

2. Verfahren nach Anspruch 1, wobei erste Seltenerdionen in den ersten anorganischen Halbleiteremissionsabschnitt (108) und/oder zweite Seltenerdionen in den zweiten anorganischen Halbleiteremissionsabschnitt (116) eingebettet sind.

3. Verfahren nach Anspruch 2, wobei die ersten Seltenerdionen in den ersten anorganischen Halbleiteremissionsabschnitt (108) eingebettet sind und die zweiten Seltenerdionen, die von den ersten Seltenerdionen abweichen, in den zweiten anorganischen Halbleiteremissionsabschnitt (116) eingebettet sind.

4. Verfahren nach einem der vorhergehenden Ansprüche, ferner umfassend, nach der Herstellung des zweiten Emissionsabschnitts (116) und vor der Herstellung des anorganischen Halbleiterabschnitts (128), der nach dem zweiten Leitfähigkeitstyp dotiert ist:

- eine Verschiebung der Maske (110) derart, dass die Öffnung (112) gegenüber mindestens einem dritten Bereich, der von dem ersten und zweiten Bereich (114, 122) des anorganischen Halbleiterabschnitts (106), der nach dem ersten Leitfähigkeitstyp dotiert ist, getrennt angeordnet ist, dann
- eine Herstellung, auf dem anorganischen Halbleiterabschnitt (106), der nach dem ersten Leitfähigkeitstyp dotiert ist, und durch die Maske (110), von mindestens einem dritten anorganischen Halbleiteremissionsabschnitt (124), dessen chemische Zusammensetzung sich von denen der ersten und zweiten Emissionsabschnitte (108, 116) unterscheidet und dessen verbotene Bandenergie kleiner oder gleich derjenigen der dotierten anorganischen Halbleiterabschnitte (106, 128) ist.

5. Verfahren nach Anspruch 4, wobei die chemischen Zusammensetzungen der ersten, zweiten und dritten Emissionsabschnitte (108, 116, 124) so gewählt sind, dass die ersten, zweiten und dritten Emissionsabschnitte jeweils in der Lage sind, Wellenlängen zu emittieren, die einer der Farben Rot, Grün und Blau entsprechen.

6. Verfahren nach einem der Ansprüche 4 oder 5, ferner umfassend, nach der Herstellung des dritten Emissionsabschnitts (124) und vor der Herstellung des anorganischen Halbleiterabschnitts (128), der nach dem zweiten Leitfähigkeitstyp dotiert ist:

- eine Verschiebung der Maske (110) derart, dass die Öffnung (112) gegenüber mindestens einem vierten Bereich, der von dem ersten, zweiten und dritten Bereich (114, 122) des anorganischen Halbleiterabschnitts (106), der nach dem ersten Leitfähigkeitstyp dotiert ist, getrennt angeordnet ist, dann
- eine Herstellung, auf dem nach dem ersten Leitfähigkeitstyp dotierten anorganischen Halbleiterabschnitt (106) und durch die Maske (110), von mindestens einem vierten anorganischen Halbleiteremissionsabschnitt (126), dessen chemische Zusammensetzung der eines der ersten, zweiten und dritten Emissionsabschnitte (108, 116, 124) ähnelt.

7. Verfahren nach einem der vorhergehenden Ansprüche, wobei die dotierten anorganischen Halbleiterabschnitte (106, 128) und die Emissionsabschnitte (108, 116, 124, 126) chemische Verbindungen umfassen, die Stickstoffatome sowie Aluminium- und/oder Gallium- und/oder Indiumatome umfassen.

8. Verfahren nach einem der vorhergehenden Ansprüche, ferner umfassend, vor der Herstellung des anorganischen Halbleiterabschnitts (106), der nach dem ersten Leitfähigkeitsabschnitt (106) dotiert ist, eine Herstellung mindestens eines sogenannten Basis-Halbleiterabschnitts (104), vorteilhafterweise GaN, der nach dem ersten Leitfähigkeitstyp auf einem Substrat dotiert ist, wobei der anorganische Halbleiterabschnitt (106), der nach dem ersten Leitfähigkeitstyp dotiert ist, anschließend an dem Basisabschnitt (104) hergestellt wird.

9. Verfahren nach Anspruch 8, wobei der Basisabschnitt (104) GaN enthält.

10. Verfahren nach einem der vorhergehenden Ansprüche, wobei die anorganischen Halbleiterabschnitte (106, 128) und die Emissionsabschnitte (108, 116, 124, 126) in Form von Nanodrähten oder planaren Schichten hergestellt werden.

11. Verfahren nach Anspruch 10, ferner umfassend, wenn die anorganischen Halbleiterabschnitte (106, 128) und die Emissionsabschnitte (108, 116, 124, 126) in Form von Nanodrähten hergestellt sind, einen Schritt der Abscheidung eines elektrischen Isoliermaterials zwischen den Nanodrähten, der nach Herstellung des anorganischen Halbleiterabschnitts (128), der nach dem zweiten Leitfähigkeitstyps dotiert ist, durchgeführt wird.

12. Verfahren nach einem der vorhergehenden Ansprüche, wobei der erste Leitfähigkeitstyp dem n-Typ und der zweite Leitfähigkeitstyp dem p-Typ entspricht.

13. Verfahren nach einem der vorhergehenden Ansprüche, wobei:

- der anorganische Halbleiterabschnitt (128), der nach dem zweiten Leitfähigkeitstyp dotiert ist, mit Magnesium- und/oder Indiumatomen dotiert ist, und/oder
- der anorganische Halbleiterabschnitt (106), der nach dem ersten Leitfähigkeitstyp dotiert ist, mit Silizium- und/oder Germaniumatomen dotiert ist.

14. Verfahren zur Herstellung einer Anzeigevorrichtung (1000), das die Durchführung des Verfahrens zur Herstellung von Leuchtdioden (100) nach einem der vorhergehenden Ansprüche umfasst.

## Claims

1. Method for producing light-emitting diodes (100), comprising at least:

- producing at least one portion (106) of inorganic semiconductor doped according to a first type of conductivity;
- producing, on the portion (106) of inorganic semiconductor doped according to the first type of conductivity and through at least one mask (110) comprising at least one opening (112) disposed facing at least one first region (114) of the portion (106) of inorganic semiconductor doped according to the first type of conductivity, at least one first emissive portion (108) of inorganic semiconductor;
- moving the mask (110) such that the opening (112) is disposed facing at least one second region (122), distinct from the first region (114), of the portion (106) of inorganic semiconductor doped according to the first type of conductivity;
- producing, on the portion (106) of inorganic semiconductor doped according to the first type of conductivity and through the mask (110), at least one second emissive portion (116) of inorganic semiconductor;
- producing, at least on the first and second emissive portions (108 116), at least one portion (128) of inorganic semiconductor doped according to a second type of conductivity opposite to the first type of conductivity,

wherein the chemical compositions of the first and second emissive portions (108, 116) are different from each other and such that their forbidden band energies are less than or equal to those of the portions (106, 128) of doped inorganic semiconductor.

2. Method according to claim 1, wherein first rare earth ions are incorporated into the inorganic semiconductor of the first emissive portion (108) and/or wherein second rare earth ions are incorporated into the inorganic semiconductor of the second emissive portion (116).

3. Method according to claim 2, wherein the first rare earth ions are incorporated into the inorganic semiconductor of the first emissive portion (108) and the second rare earth ions, of a different nature than the first rare earth ions, are incorporated into the inorganic semiconductor of the second emissive portion (116).

4. Method according to one of the preceding claims, further comprising, after the production of the second emissive portion (116) and before the production of the portion (128) of inorganic semiconductor doped according to the second type of conductivity:

   - moving the mask (110) such that the opening (112) is disposed facing at least one third region, distinct from the first and second regions (114, 122), of the portion (106) of inorganic semiconductor doped according to the first type of conductivity, then
   - producing, on the portion (106) of inorganic semiconductor doped according to the first type of conductivity and through the mask (110), at least one third emissive portion (124) of inorganic semiconductor, the chemical composition of which is different than those of the first and second emissive portions (108, 116) and such that its forbidden band energy is less than or equal to those of the portions (106, 128) of doped inorganic semiconductor.

5. Method according to claim 4, wherein the chemical compositions of the first, second and third emissive portions (108, 116, 124) are chosen such that the first, second and third emissive portions are each capable of emitting wavelengths corresponding to one of the colours red, green and blue.

6. Method according to one of claims 4 or 5, further comprising, after the production of the third emissive portion (124) and before the production of the portion (128) of inorganic semiconductor doped according to the second type of conductivity:

   - moving the mask (110) such that the opening (112) is disposed facing at least one fourth region, distinct from the first, second and third regions (114, 122), of the portion (106) of inorganic semiconductor doped according to the first type of conductivity, then
   - producing, on the portion (106) of inorganic semiconductor doped according to the first type of conductivity and through the mask (110), at least one fourth emissive portion (126) of inorganic semiconductor, the chemical composition of which is similar to that of one of the first, second and third emissive portions (108, 116, 124).

7. Method according to one of the preceding claims, wherein the portions (106, 128) of doped inorganic semiconductor and the emissive portions (108, 116, 124, 126) comprise chemical compounds comprising atoms of nitrogen as well as atoms of aluminium and/or of gallium and/or of indium.

8. Method according to one of the preceding claims, further comprising, before the production of the portion (106) of inorganic semiconductor doped according to the first type of conductivity, a production of at least one portion (104), called base portion, of semiconductor, advantageously of GaN, doped according to the first type of conductivity on a substrate, the portion (106) of inorganic semiconductor doped according to the first type of conductivity being then produced on the base portion (104).

9. Method according to claim 8, wherein the base portion (104) comprises GaN.

10. Method according to one of the preceding claims, wherein the portions (106, 128) of inorganic semiconductor and the emissive portions (108, 116, 124, 126) are produced in the form of nanowires or of planar layers.

11. Method according to claim 10, further comprising, when the portions (106, 128) of inorganic semiconductor and the emissive portions (108, 116, 124, 126) are produced in the form of nanowires, a step of depositing an electric insulant material between the nanowires, implemented after the production of the portion (128) of inorganic semiconductor doped according to the second type of conductivity.

12. Method according to one of the preceding claims, wherein the first type of conductivity corresponds to the n type and the second type of conductivity corresponds to the p type.

13. Method according to one of the preceding claims, wherein:

   - the portion (128) of inorganic semiconductor doped according to the second type of conductivity is doped by atoms of magnesium and/or of indium, and/or
   - the portion (106) of inorganic semiconductor doped according to the first type of conductivity is doped by atoms of silicon and/or of germanium.

14. Method for producing a display device (1000), comprising the implementation of the method for producing light-emitting diodes (100) according to one of the preceding claims.

FIG.1

FIG.2

FIG.3

FIG.4

FIG.5

FIG.6

FIG.7

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0526266 A1

**Littérature non-brevet citée dans la description**

- **S. ICHIKAWA et al.** Eu-doped GaN and InGaN monolithically stacked full-color LEDs with a wide color gamut. *Appl. Phys. Express*, 2021, vol. 14, 031008